(19) Europäisches Patentamt
European Patent Office
Office européen des brevets

(11) EP 1 370 002 A1

(12) **EUROPEAN PATENT APPLICATION**

(43) Date of publication:
**10.12.2003 Bulletin 2003/50**

(51) Int Cl.⁷: **H03M 5/14**, H03M 13/45, G11B 20/14

(21) Application number: **03252226.0**

(22) Date of filing: **09.04.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **03.06.2002 KR 2002031065**

(71) Applicant: **SAMSUNG ELECTRONICS CO., LTD.**
**Suwon-City, Kyungki-do (KR)**

(72) Inventors:
- **Kim, Ki-hyun**
**Bundang-gu, Seongnam-si, Gyeonggi-do (KR)**
- **Han, Sung-hyu**
**Gnagnam-gu, seoul (KR)**
- **Park, In-sik**
**Paldal-gu, Suwon-si, Gyeonggi-do (KR)**
- **Shim, Jae-seong**
**Seoul (KR)**

(74) Representative: **Robinson, Ian Michael et al**
**Appleyard Lees,**
**15 Clare Road**
**Halifax HX1 2HY (GB)**

(54) **Apparatus and method for demodulating signals**

(57) The signal demodulation apparatus comprises a reliability detection unit (110) which receives data indicating the probability value of the code, and after forming data of a predetermined length L as one unit, compares the absolute value of each probability value forming the one unit with a predetermined reference value, and outputs location information and sign information of probability data values that are greater than the predetermined reference value; a sign comparison unit (120) which receives the location information and sign information of probability data values that are greater than the predetermined reference value, and using a plurality of codewords stored in advance, compares the sign of a code of a codeword corresponding to the location of the data with the sign information, and outputs a plurality of codewords in which the signs are the same; and a data word probability value calculation unit (130) which receives the plurality of codewords that are the output of the sign comparison unit (120), and data indicating the probability value of the code and calculates a value indicating the probability of a bit for each bit forming the data word. With this signal demodulation apparatus, computation speed increases and complexity of a system decreases.

FIG. 1

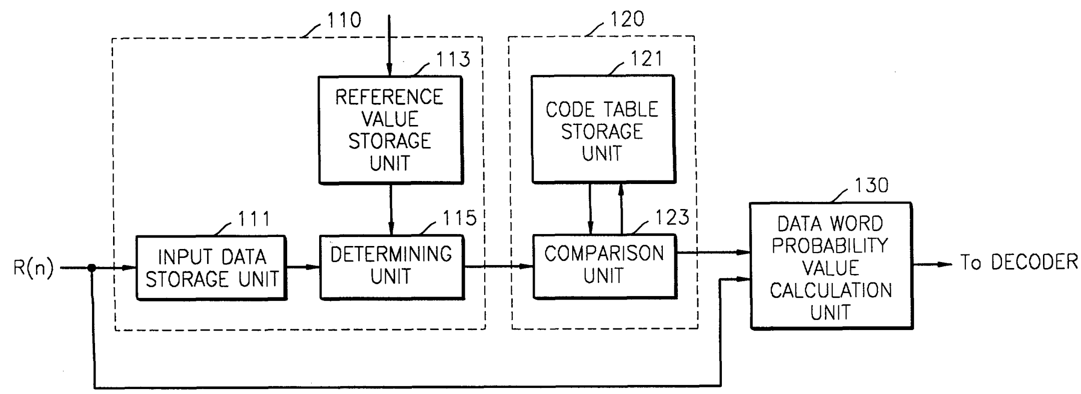


EP 1 370 002 A1

## Description

The present invention relates to a signal demodulation apparatus and method, and more particularly, to a signal demodulation apparatus and method for demodulation of a run length limit (RLL) code.

Generally, in an environment where there is inter symbol interference (ISI) of data, for example, in a high density optical recording medium, an RLL code is used to modulate data and so reduce problems caused by this ISI phenomena.

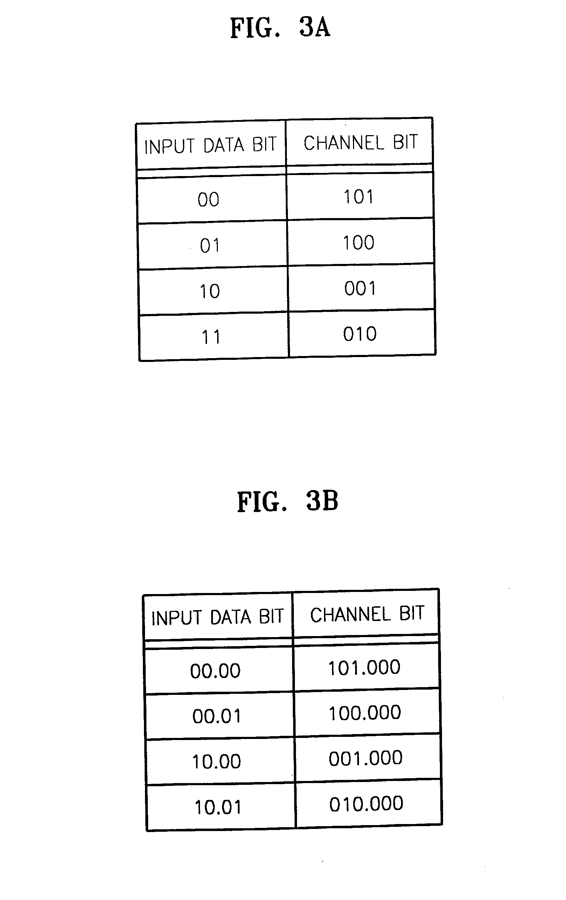

Figures 3A and 3B show RLL encoding tables of a (1, 7) code. Figure 3A shows a basic encoding table when a code having a code rate of 2/3 is used, and Figure 3B shows a replacement table for a violation occurring when the basic encoding table of Figure 3A is used.

The (1, 7) code is a code in which the minimum number of contiguous 0's between a 1 and the next 1 in a modulated signal is 1 and the maximum number thereof is 7. The code rate of 2/3 indicates modulation of a 2-bit data word into a 3-bit codeword.

However, when the basic encoding table of Figure 3A is used, a violation of the rule described above occurs. For example, when input data bits are 0000 according to the basic encoding table of Figure 3A, the encoded channel bits are 101101, and thus, 1 occurs continuously. In order to solve the above problem, the replacement table shown in Figure 3B is used so that the encoding rule can be observed considering relations of input data with previous input data and next input data. Accordingly, in order to obtain a 2-bit data word through decoding, a 9-bit codeword is decoded.

In a conventional method for decoding an RLL code, a channel detector, for example a viterbi decoder, receives a channel signal, detects codewords and outputs the detected codewords. An RLL decoding unit decodes the codewords into data words using an RLL decoding table.

Recently, however, the concepts of a soft channel detector and a soft modulator have been introduced. The output of the viterbi decoder described above is a codeword itself, and has a value of 1 or -1. When the above method is referred to as a hard demodulation, there is a soft demodulation method contrary to the hard demodulation. In the soft demodulation, a soft channel detector receives a channel signal, and outputs data indicating a probability value of a codeword. That is, the data has an analog value, such as 0.8 or -0.8 instead of 1 or -1, and the value itself indicates a probability that the code value is 1 or -1. A soft demodulator receives data indicating the probability value of the codeword, and outputs data indicating the probability of a data word. Then, a decoder such as a turbo decoder finally decodes a data word.

There is detailed description of soft modulation in an article entitled "Near-optimum Decoding of Product Codes" (R.Pyndiah, IEEE Trans. on Commun. vol. 46, No. 8, pp1003-10). As for the soft channel detector, there are detailed explanations in articles entitled "A Comparison of Optimal and Sub-optimal MAP Decoding Algorithms Operating in the Log Domain" (P. Robertson, E. Villebrun, and P. Hoeher, Communications, 1995, ICC '95 Seattle, 'Gateway to Globalization', 1995 IEEE International Conference on, vol. 2, 1995 pp1009-1013 vol. 2) and "A Viterbi Algorithm with Soft Decision Outputs and Its Applications," (J. Hagenauer and P. Hoeher, Proc. GLOBECOM, '89, pp1680-1786, Nov. 1989). As for turbo decoding requiring soft modulation, there is a detailed explanation in an article entitled "Turbo Decoding with RLL Code for Optical Storage" (E. Yamade, ISOMO1).

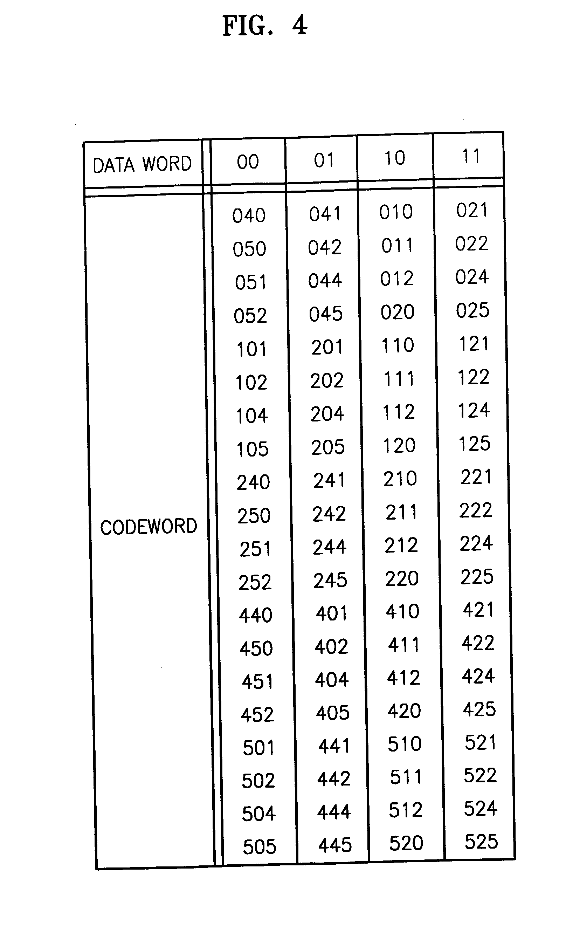

Referring to Figure 4, a process in which the soft demodulator described above receives R(n), which is data indicating the probability value of a codeword, and obtains a likelihood ratio (LR), which is a value indicating the probability of each bit forming a data word, will now be explained.

Here, an example in which the code rate is 2/3 and the RLL(1, 7) code is used will be explained. Figure 4 shows a decoding table of the RLL(1, 7) code. The first line shows data words with a 2-bit length, which are the results of decoding. The remaining lines show codewords represented in a hexadecimal notation, each codeword corresponding to a data word. For example, codeword 040 corresponds to a binary number 000 100 000.

First, in order to obtain an LR, APP(d=1) and APP(d=0) are obtained. APP(d=1) is a value indicating the probability that demodulated data is 1, and APP(d=0) is a value indicating the probability that demodulated data is 0.

APP(d=1) and APP(d=0) are obtained by equation 1 as follows:

$$APP(d=1)=\sum_{i=1}^{s1}\exp[\sum_{l=1}^{L}(C_l^i-R_l)^2] \quad ......(1)$$

In equation 1, since the code rate is 2/3, L is 9. $R_l$ is a value indicating the probability value of a bit which is the 1-th bit of 9 data bits respectively indicating probability values of 9 code bits forming one codeword that is input to the soft demodulator. $C_l^i$ is a probability value of a bit which is the l-th bit of 9 code bits that form an i-th codeword among s1 codewords corresponding to a data word having 1 as the first bit. Referring to Figure 4, since the number

of codewords corresponding to a data word having 1 as the first bit is 40, s1 is 40.

$$APP(d=0)=\sum_{h=1}^{s2}\exp[\sum_{l=1}^{L}(C_l^h-R_l)^2] \quad ......(2)$$

In equation 2, L is 9 and $R_l$ is the same as in equation 1. $C_l^h$ is a probability value of a bit which is the l-th bit of 9 code bits that form an h-th codeword among s2 codewords corresponding to a data word having 0 as the first bit. Referring to Figure 4, since the number of codewords corresponding to a data word having 0 as the first bit is 40, s2 is 40.

After obtaining APP(d=1) and APP(d=0) according to equations 1 and 2, an LR is obtained by equation 3 as follows:

$$LR=APP(d=1)\div APP(d=0) \quad ......(3)$$

Meanwhile, if computation of the exponent term is complicated in equations 1 and 2, the computation of the exponent part is not carried out and instead, APP(d=1) and APP(d=2) are obtained by equations 4 and 5 and an LR is obtained by equation 6:

$$APP(d=1)=Max[(\sum_{l=1}^{L}(C_l^1-R_l)^2),...,(\sum_{l=1}^{L}(C_l^{s1}-R_l)^2)] \quad ......(4)$$

In equation 4, $R_l$ and $C_l^i$ are the same as in equation 1, and L and s1 are 9 and 40, respectively, as in equation 1. That is, in equation 4, a maximum value among 40 values satisfying

$$\sum_{l=1}^{9}(c_l^i-R_l)^2$$

is determined as APP(d=1).

$$APP(d=0)=Max[(\sum_{l=1}^{L}(C_l^1-R_l)^2),...,(\sum_{l=1}^{L}(C_l^{s2}-R_l)^2)] \quad ......(5)$$

In equation 5, $R_l$ and $C_l^h$ are the same as in equation 2, and L and s2 are 9 and 40, respectively, as in equation 2. That is, in equation 5, a maximum value among 40 values satisfying

$$\sum_{l=1}^{9}(C_l^h-R_l)^2$$

is determined as APP(d=0).

After APP(d=1) and APP(d=0) are obtained according to equations 4 and 5, an LR is obtained by equation 6 as follows:

$$LR = APP(d = 1) - APP(d = 0) \tag{6}$$

However, if an LR is obtained by the method described above, LR should be calculated using all codewords corresponding to a 1-bit data word. Accordingly, the more complicated a code is, the longer the computation time and the greater the complexity.

An aim of the present invention is to reduce complexity and increase computation speed when demodulating a coded signal, particularly a run length limited (RLL) code.

According to the present invention there is provided an apparatus and method as set forth in the appended claims. Preferred features of the invention will be apparent from the dependent claims, and the description which follows.

The present invention provides a signal demodulation apparatus which, by using data having high reliability among data indicating probability values of a codeword, decreases the number of codewords used in calculation of a value indicating the probability of a data word such that computation speed increases and complexity decreases.

The present invention also provides a signal demodulation method by which, by using data having high reliability among data indicating probability values of a codeword, the number of codewords used in calculation of a value indicating the probability of a data word is reduced such that computation speed increases and complexity decreases.

According to an aspect of the present invention, there is provided a signal demodulation apparatus which demodulates a code that is modulated from an N-bit data word into an M-bit codeword. The signal demodulation apparatus comprises a reliability detection unit which receives data indicating the probability value of the code, and after forming data of a predetermined length L as one unit, compares the absolute value of each of probability values forming the one unit with a predetermined reference value, and outputs location information and sign information of probability value data greater than the predetermined reference value; a sign comparison unit which receives the location information and sign information of probability value data greater than the predetermined reference value, and using a plurality of codewords stored in advance, compares the sign of a code of a codeword corresponding to the location of the data with the sign information, and outputs a plurality of codewords in which the signs are the same; and a data word probability value calculation unit which receives the plurality of codewords output from the sign comparison unit, and data indicating the probability value of the code and calculates a value indicating the probability of the bit for each of bits forming the data word.

The reliability detection unit comprises a reference value storage unit which stores the predetermined reference value; an input data storage unit which receives the data indicating the probability value of a code, and stores the data in units of data of a predetermined length L; and a determining unit which receives each of the probability value data from the input data storage unit, receives the predetermined reference value from the reference value storage unit, performs the comparison, and outputs the location and sign information of the probability value data.

The sign comparison unit comprises a code table storage unit which stores a codeword table in which a plurality of codewords corresponding to a data word are written; and a comparison unit which reads a codeword from the code table storage unit, performs the sign comparison, and outputs a plurality of codewords in which the signs are the same.

According to another aspect of the present invention, there is provided a signal demodulation method for demodulating a code that is modulated from an N-bit data word into an M-bit codeword. The method comprises (a) a reliability detection step for receiving data indicating the probability value of the code, and after forming data of a predetermined length L as one unit, comparing the absolute value of each of probability values forming the one unit with a predetermined reference value, and outputting location information and sign information of probability value data greater than the predetermined reference value; (b) a sign comparison step for receiving the location information and sign information of probability value data greater than the predetermined reference value, and using a plurality of codewords stored in advance, comparing the sign of a code of a codeword corresponding to the location of the data, with the sign information, and outputting a plurality of codewords in which the signs are the same; and (c) a data word probability value calculation step for receiving the plurality of codewords output from the sign comparison unit and data indicating the probability value of the code and calculating a value indicating the probability of the bit for each of bits forming the data word.

In the signal demodulation method, step (a) comprises (a1) a reference value storage step for storing the predetermined reference value; (a2) an input data storage step for receiving the data indicating the probability value of a code, and storing the data in units of data of a predetermined length L; and (a3) a determining step for performing the comparison of step (a), by using the probability value data and the predetermined reference value, and outputting the location and sign information of the probability value data.

In the signal demodulation method, step (b) further comprises a code table storage step for storing a codeword table including a plurality of codewords corresponding to a data word.

For a better understanding of the invention, and to show how embodiments of the same may be carried into

effect, reference will now be made, by way of example, to the accompanying diagrammatic drawings in which:

Figure 1 is a block diagram of a preferred embodiment of a signal demodulation apparatus according to the present invention;

Figure 2 is a flowchart for explaining a preferred embodiment of a signal demodulation method according to the present invention shown in Figure 1;

Figures 3A and 3B are preferred embodiments of RLL encoding tables;

Figure 4 is a preferred embodiment of a decoding table of an RLL (1, 7) code; and

Figure 5 is a schematic diagram for explaining an example in which codewords having the same sign as input data having high reliability are determined in a signal demodulation apparatus and a method according to the present invention.

In preferred embodiments of the present invention, an example will be explained in which the code rate is 2/3 and the RLL(1, 7) code is used.

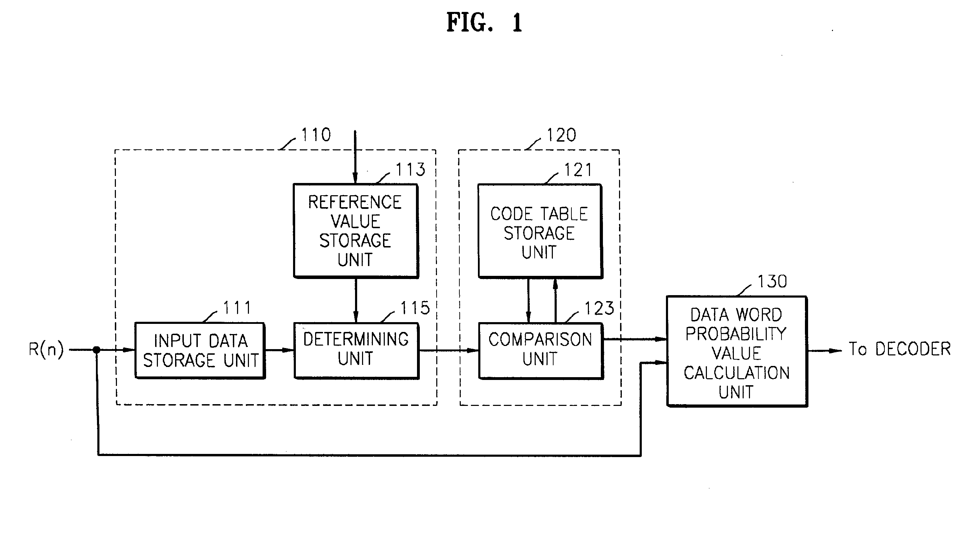

First, referring to Figures 1, 4, and 5, the structure and operation of a signal demodulation apparatus according to the present invention will now be explained.

Figure 1 is a block diagram of a preferred embodiment of a signal demodulation apparatus according to the present invention. The signal demodulation apparatus comprises a reliability detection unit 110, a sign comparison unit 120, and a data word probability value calculation unit 130. The reliability detection unit 110 comprises an input data storage unit 111, a reference value storage unit 113, and a determining unit 115. The sign comparison unit 120 comprises a code table storage unit 121 and a comparison unit 123.

First, the input data storage unit 111 receives R(n), which is the output of a soft channel detector, for example, a soft viterbi decoder or a maximum a posteriori probability (MAP) decoder, and indicates the probability value of a code bit. Then, the input data storage unit 111 stores every 9 data values, including R(1), R(2), ... R(9), as one unit. In order to decode a 2-bit data word, a 9-bit codeword is needed, and in order to apply 9 data values to equations 1, 2, 4, and 5, the 9 data values are stored as one unit and are output to the determining unit 115.

The reference value storage unit 113 stores a predetermined reference value and outputs the value to the determining unit 115. The reference value may change according to an input from the outside.

The determining unit 115 receives data $R_k$ (k=1, 2, ..., 9), which is formed by 9 probability value data values $R_1$, $R_2$, ..., $R_9$ as one unit, from the input data storage unit 111, and receives a predetermined reference value S from the reference value storage unit 113. Then, the determining unit 115 compares each ABS($R_k$), that is, the absolute value of each data unit, with the predetermined reference value, and outputs information on the location and sign of $R_k$ values that are greater than the predetermined reference value, to the comparison unit 123. Though 0.8 is used as the predetermined reference value in the present embodiment, the value may change. Accordingly, if the value of $R_k$ is equal to or greater than 0.8, the probability that the data value is 1 is very high and therefore the data value has high reliability. If the value of $R_k$ is equal to or less than -0.8, the probability that the data value is -1 is very high and the data value also has high reliability.

The code table storage unit 121 stores a codeword table in which a plurality of codewords are written as shown in Figure 4.

The comparison unit 123 receives information on the locations and signs of a plurality of $R_k$, values that are greater than the predetermined reference value, from the determining unit 115. Then, the comparison unit 123 first reads a plurality of codeword corresponding to a data word having 1 as the first bit, from the code table storage unit 121. Referring to Figure 4, the codewords corresponding to a data word having 1 as the first bit are codewords in the third and fourth lines, and the number of codewords in the third and fourth lines is 40. Then, the comparison unit 123 compares the signs of bits of a codeword corresponding to the received information on the locations of a plurality of $R_k$ values that are greater than the predetermined reference value, with the received information on the signs of a plurality of $R_k$ values that are greater than the predetermined reference value, and by selecting the codeword when the signs are the same, determines S1 which is a set of thus selected codewords.

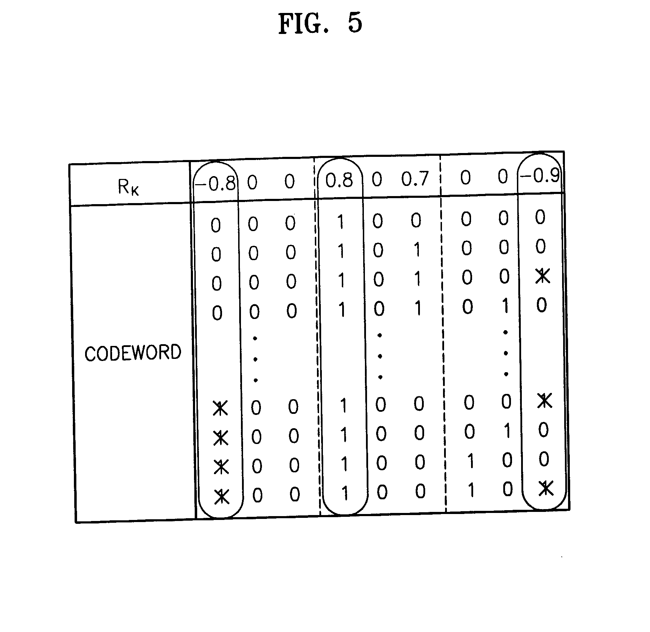

Figure 5 is a schematic diagram showing an example process for determining S1 Assuming that $R_k$ is (-0.8 0 0 0.8 0 0.7 0 0 -0.9) and the reference value is 0.8, the determining unit 115 outputs to the comparison unit 123 information on locations, that is, k is 1, 4 and 9, and information on signs, that is, -1, +1, and -1, respectively. The comparison unit 123 reads 40 codewords in the third and fourth lines of the table of Figure 4, and performs sign comparison as shown in Figure 5. Since $R_k$ values whose location is 1 having the sign of -1, the comparison unit 123 compares the signs of codewords corresponding to location 1 and removes codewords having the sign of +1. Since a

code bit of a codeword that is 0 actually corresponds to -1, the code bit 0 is selected. When the location k is 4 and 9, the same sign comparison is performed and the first and second codewords among the 8 codewords shown in Figure 5 are selected and output to the data word probability value calculation unit 130.

Next, the comparison unit 123 reads a plurality of codewords corresponding to a data word having -1 as the first bit. Referring to Figure 4, the codewords corresponding to a data word having -1 as the first bit are codewords in the first and second lines, and the number of codewords in the first and second lines is 40. Then, through sign comparison as described above, the comparison unit 123 determines S2, which is a set of a plurality of codewords selected when the signs are the same.

The data word probability value calculation unit 130 receives S1 from the comparison unit 123, receives R (1), R(2) , ... , R(9), which are the same data as the data input to and stored in the input data storage unit 111, and then calculates APP(d=1) according to equation 1 or 4. The data word probability value calculation unit 130 receives S2 from the comparison unit 123 and calculates APP(d=0) according to equation 2 or 5. Meanwhile, the value of s1 in equations 1 and 4 is, for example, 40, in the prior art described above, but the number of elements of the set S1 is s1 in the embodiment of the present invention. Also, the value of s2 in equations 2 and 5 is 40 in the prior art described above, but the number of elements of the set S2 is s2 in the embodiment of the present invention. Since the number of remaining codewords excluding codeword, in which the signs are the same, is s1 or s2, s1 and s2 should be numbers equal to or less than 40, and accordingly the number of computations needed to calculate equations 1 through 6 is reduced. The data word probability calculation unit 130 calculates APP(d=1) and APP(d=0) and then, using equation 3 or 6, calculates and outputs an LR. The LR, which is the output of the data word probability value calculation unit 130, is input to a decoder such as a turbo decoder and a data word is finally decoded.

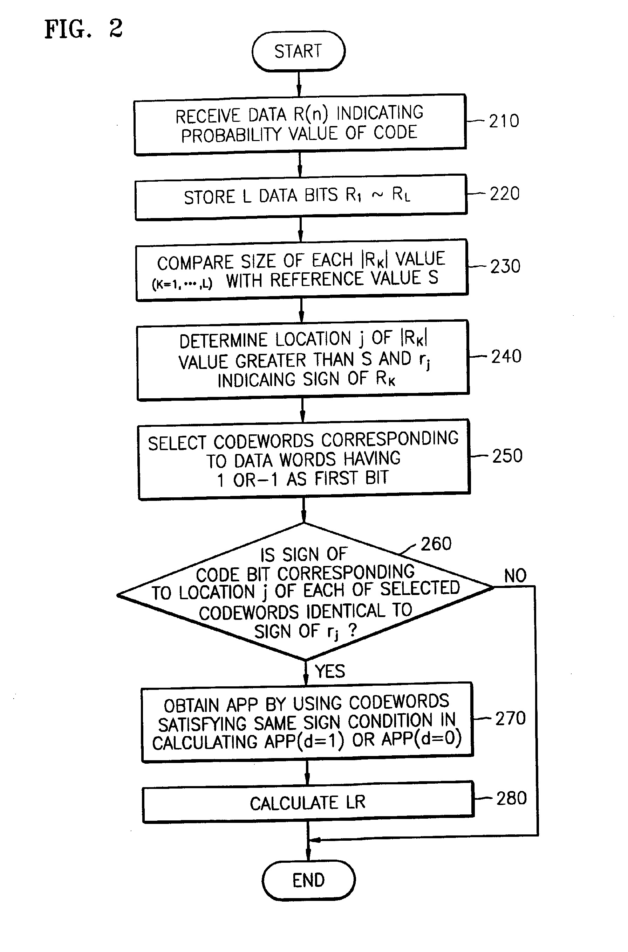

Referring to Figures 1 and 2, an embodiment of a signal demodulation method according to the present invention will now be explained. Figure 2 is a flowchart for explaining a preferred embodiment of a signal demodulation method according to the present invention, which is implemented by the signal demodulation apparatus according to the present invention shown in Figure 1.

First, the input data storage unit 111 receives data R(n) that indicates the probability value of a code bit in step 210.

After receiving R(n), the input data storage unit 111 stores L data bits $R_1$, $R_2$, ... , $R_L$ as one unit in step 220.

The determining unit 115 receives data $R_k$ (k=1, 2, ..., L) that is formed by 9 probability values $R_1$, $R_2$, ... , $R_L$ as one unit, from the input data storage unit 111, receives a predetermined reference value S from the reference value storage unit 113, and compares each ABS($R_k$), that is, the absolute value of each value, with the predetermined reference value S in step 230.

The determining unit 115 determines location information j of $R_k$ values that are greater than the predetermined reference value S and $r_j$ indicating sign information in step 240.

The comparison unit 123 receives $r_j$ and selects and reads codewords corresponding to a data word having 1 as the first bit, and codewords corresponding to a data word having -1 as the first bit, from the code table storage unit 121 in step 250.

Among codewords corresponding to a data word having 1 as the first bit and a data word having -1 as the first bit, the comparison unit 123 compares the signs of bits of a codeword corresponding to the location information j of a plurality of $R_k$ values that are greater than the received predetermined reference value S, with sign information $r_j$. By selecting a codeword when the signs are the same, the comparison unit 123 determines S1 which is formed by codewords selected among a plurality of codewords corresponding to the data word having 1 as the first bit, and S2, which is formed by codewords selected among a plurality of codewords corresponding to the data word having -1 as the first bit in step 260.

The data word probability calculation unit 130 receives S1 and S2 from the comparison unit 123, receives R (1), R(2), ... , R(9) that are the same data as the data input to and stored in the input data storage unit 111, and then calculates APP(d=1) according to equation 1 or 4, and calculates APP(d=0) according to equation 2 or 5. The value of s1 in equations 1 and 4 becomes the number of elements of the set S1 and the value of s2 in equations 2 and 5 becomes the number of elements of the set S2 in step 270.

The data word probability calculation unit 130 calculates the LR using equation 3 or 6 in step 280.

The present invention may be embodied in a code, which can be read by a computer, on a computer readable recording medium. The computer readable recording medium includes all kinds of recording apparatuses on which computer readable data are stored.

The computer readable recording media includes storage media such as magnetic storage media (e.g., ROM's, floppy disks, hard disks, etc.), optically readable media (e.g., CD-ROMs, DVDs, etc.) and carrier waves (e.g., transmissions over the Internet). Also, the computer readable recording media can be scattered on computer systems connected through a network and can store and execute a computer readable code in a distributed mode.

As described above, the signal demodulation apparatus and method according to the present invention, by using data having high reliability among data indicating probability values of a codeword, decreases the number of

codewords used in calculation of a value indicating the probability of a data word such that a computation speed increases and complexity of the system decreases.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

**1.** A signal demodulation apparatus which demodulates a code that is modulated from an N-bit data word into an M-bit codeword, comprising:

a reliability detection unit (110) which receives data indicating the probability value of the code, and after forming data of a predetermined length L as one unit, compares the absolute value of each probability value forming the one unit with a predetermined reference value, and outputs location information and sign information of probability data values that are greater than the predetermined reference value;

a sign comparison unit (120) which receives the location information and sign information of probability data values that are greater than the predetermined reference value, and using a plurality of codewords stored in advance, compares the sign of a code of a codeword corresponding to the location of the data with the sign information, and outputs a plurality of codewords in which the signs are the same; and

a data word probability value calculation unit (130) which receives the plurality of codewords that are the output of the sign comparison unit (120), and data indicating the probability value of the code and calculates a value indicating the probability of a bit for each bit forming the data word.

**2.** The signal demodulation apparatus of claim 1, wherein the reliability detection unit (110) comprises:

a reference value storage unit (113) which stores the predetermined reference value;

an input data storage unit (111) which receives the data indicating the probability value of a code, and stores the data in units of data of a predetermined length L; and

a determining unit (115) which receives each of the probability value data from the input data storage unit (111), receives the predetermined reference value from the reference value storage unit (113), performs the comparison, and outputs the location and sign information of the probability value data.

**3.** The signal demodulation apparatus of claim 1 or 2, wherein the sign comparison unit (120) comprises:

a code table storage unit (121) which stores a codeword table in which a plurality of codewords corresponding to a data word are written; and

a comparison unit (123) which reads a codeword from the code table storage unit (121), performs the sign comparison, and outputs a plurality of codewords in which the signs are the same.

**4.** The signal demodulation apparatus of claim 3, wherein the sign comparison unit (120) reads codewords corresponding to a data word having 1 as the first bit, from the code table storage unit (121), performs the sign comparison, and outputs S1 which is a set of a plurality of codewords in which the signs are the same, and reads codewords corresponding to a data word having -1 as the first bit, from the code table storage unit (121), performs the sign comparison, and outputs S2, which is a set of a plurality of codewords in which the signs are the same,

**5.** The signal demodulation apparatus of claim 6, wherein the data word probability value calculation unit (130) obtains an LR, which is a value indicating the probability of each bit forming the data word, according to the following equations:

$$APP(d=1)=\sum_{i=1}^{s1}\exp[\sum_{l=1}^{L}(C_l^i-R_l)^2]$$

$$APP(d=0)=\sum_{h=1}^{s2}\exp[\sum_{l=1}^{L}(C_l^h-R_l)^2]$$

$$LR = APP(d = 1) \div APP(d = 0)$$

where s1 is a value corresponding to the number of elements of the set S1, s2 is a value corresponding to the number of elements of the set S2, $R_l$ is a value indicating the probability value of a bit which is the l-th bit of the probability value data having the unit length L, $C_l^i$ is a value indicating the probability value of a bit which is the l-th bit of L code bits forming an i-th codeword among the s1 codewords, and $C_l^h$ is a value indicating the probability value of a bit which is the l-th bit of L code bits forming an h-th codeword among the s2 codewords.

**6.** The signal demodulation apparatus of claim 6, wherein the data word probability value calculation unit (130) obtains an LR, which is a value indicating the probability of each bit forming the data word, according to the following equations:

$$APP(d=1)=Max[(\sum_{l=1}^{L}(C_l^1-R_l)^2),\ldots,(\sum_{l=1}^{L}(C_l^{s1}-R_l)^2)]$$

$$APP(d=0)=Max[(\sum_{l=1}^{L}(C_l^1-R_l)^2),\ldots,(\sum_{l=1}^{L}(C_l^{s2}-R_l)^2)]$$

$$LR = APP(d = 1) - APP(d = 0)$$

where s1 is a value corresponding to the number of elements of the set S1, s2 is a value corresponding to the number of elements of the set S2, $R_l$ is a value indicating the probability value of a bit which is the l-th bit of the probability value data having the unit length L, $C_l^k$ in the equation to obtain APP(d=1) is a value indicating the probability value of a bit which is the l-th bit of L code bits forming an k-th codeword among the s1 codewords, and $C_l^j$ in the equation to obtain APP(d=0) is a value indicating the probability value of a bit which is the l-th bit of L code bits forming a j-th codeword among the s2 codewords.

**7.** The signal demodulation apparatus of any preceding claim, wherein the predetermined length L is 3 times the length M of the codeword.

**8.** A signal demodulation method for demodulating a code that is modulated from an N-bit data word into an M-bit

codeword, comprising:

(a) a reliability detection step for receiving data indicating the probability value of the code, and after forming data of a predetermined length L as one unit, comparing the absolute value of each probability value forming the one unit with a predetermined reference value, and outputting location information and sign information of probability value data greater than the predetermined reference value;

(b) a sign comparison step for receiving the location information and sign information of probability data values that are greater than the predetermined reference value, and using a plurality of codewords stored in advance, comparing the sign of a code of a codeword corresponding to the location of the data with the sign information, and outputting a plurality of codewords in which the signs are the same; and

(c) a data word probability value calculation step for receiving the plurality of codewords that are the output of the sign comparison unit (120), and data indicating the probability value of the code, and calculating a value indicating the probability of a bit for each bit forming the data word.

**9.** The signal demodulation method of claim 8, wherein step (a) comprises:

(a1) a reference value storage step for storing the predetermined reference value;

(a2) an input data storage step for receiving the data indicating the probability value of a code, and storing the data in units of data of a predetermined length L; and

(a3) a determining step for performing the comparison of step (a), by using the probability value data and the predetermined reference value, and outputting the location and sign information of the probability value data.

**10.** The signal demodulation method of claim 8 or 9, wherein step (b) further comprises:

a code table storage step for storing a codeword table in which a plurality of codewords corresponding to a data word are written.

**11.** The signal demodulation method of claim 8, 9 or 10, wherein in step (b), codewords corresponding to a data word having 1 as the first bit are read from the code table storage unit (121), the sign comparison is performed, and S1 which is a set of a plurality of codewords in which the signs are the same is output, and codewords corresponding to a data word having -1 as the first bit are read from the code table storage unit (121), the sign comparison is performed, and S2, which is a set of a plurality of codewords in which the signs are the same is output.

**12.** The signal demodulation method of claim 11, wherein in step (c), an LR that is a value indicating the probability of each bit forming the data word is obtained according to the following equations:

$$APP(d=1)=\sum_{i=1}^{s1}\exp[\sum_{l=1}^{L}(C_l^i-R_l)^2]$$

$$APP(d=0)=\sum_{h=1}^{s2}\exp[\sum_{l=1}^{L}(C_l^h-R_l)^2]$$

$$LR = APP(d = 1) \div APP(d = 0)$$

where s1 is a value corresponding to the number of elements of the set S1, s2 is a value corresponding to the number of elements of the set S2, $R_l$ is a value indicating the probability value of a bit which is the l-th bit of the probability value data having the unit length L, $C_l^i$ is a value indicating the probability value of a bit which is the l-th bit of L code bits forming an i-th codeword among the s1 codewords, and $C_l^h$ is a value indicating the probability value of a bit which is the l-th bit of L code bits forming an h-th codeword among the s2 codewords.

**13.** The signal demodulation method of claim 11, wherein in step (c), an LR that is a value indicating the probability of each bit forming the data word is obtained according to the following equations:

$$APP(d=1) = Max[(\sum_{l=1}^{L}(C_l^1 - R_l)^2),...,(\sum_{l=1}^{L}(C_l^{s1} - R_l)^2)]$$

$$APP(d=0) = Max[(\sum_{l=1}^{L}(C_l^1 - R_l)^2),...,(\sum_{l=1}^{L}(C_l^{s2} - R_l)^2)]$$

$$LR = APP(d = 1) - APP(d = 0)$$

where s1 is a value corresponding to the number of elements of the set S1 s2 is a value corresponding to the number of elements of the set S2, $R_l$ is a value indicating the probability value of a bit which is the l-th bit of the probability value data having the unit length L, $C_l^k$ in the equation to obtain APP(d=1) is a value indicating the probability value of a bit which is the l-th bit of L code bits forming an k-th codeword among the s1 codewords, and $C_l^j$ in the equation to obtain APP(d=0) is a value indicating the probability value of a bit which is the l-th bit of L code bits forming a j-th codeword among the s2 codewords.

**14.** The signal demodulation method of any of claims 8 to 13, wherein the predetermined length L is 3 times the length of the codeword that is M.

**15.** A computer readable medium having embodied thereon a computer program for a signal demodulation method for demodulating a code that is modulated from an N-bit data word into an M-bit codeword and is transmitted through a channel, wherein the signal demodulation method comprises:

(a) a reliability detection step for receiving data indicating the probability value of the code, and after forming data of a predetermined length L as one unit, comparing the absolute value of each probability value forming the one unit with a predetermined reference value and outputting location information and sign information of probability data values that are greater than the predetermined reference value;

(b) a sign comparison step for receiving the location information and sign information of probability data values that are greater than the predetermined reference value, and using a plurality of codewords stored in advance, comparing the sign of a code of a codeword corresponding to the location of the data with the sign information, and outputting a plurality of codewords in which the signs are the same; and

(c) a data word probability value calculation step for receiving the plurality of codewords that are the output of the sign comparison unit (120), and data indicating the probability value of the code, and calculating a value indicating the probability of a bit for each bit forming the data word.

FIG. 1

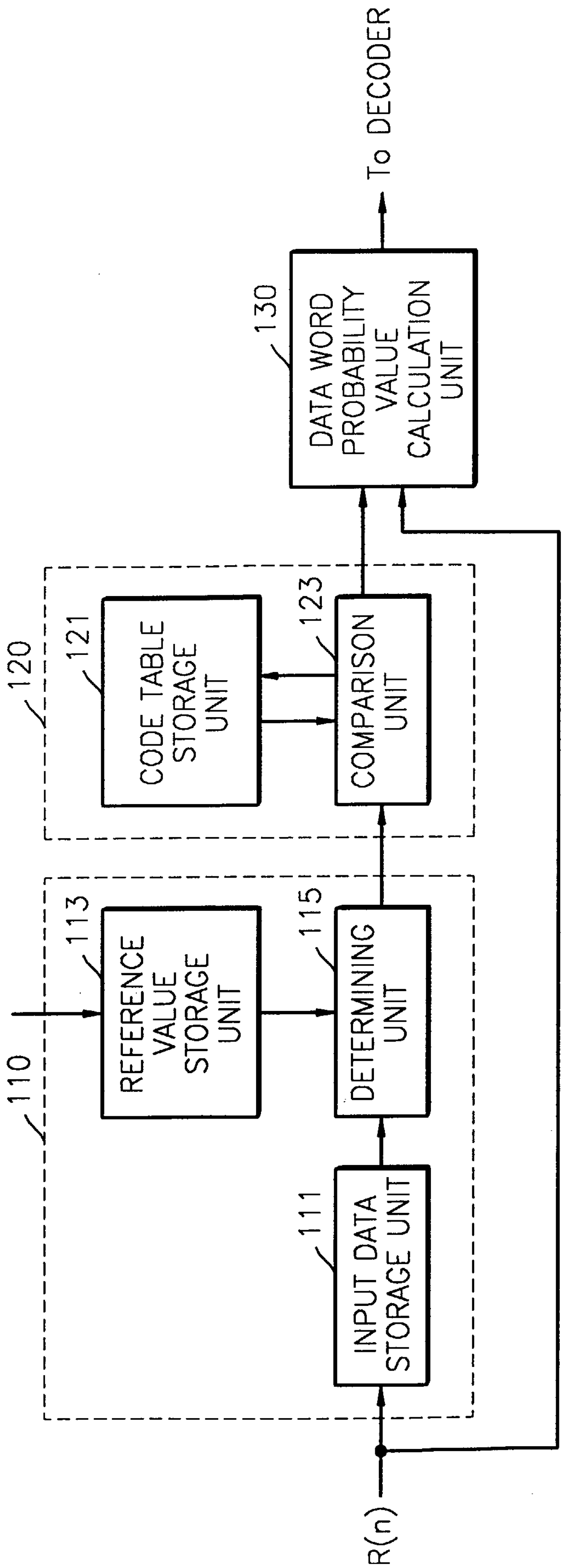
R(n)
110
111
INPUT DATA STORAGE UNIT
113
REFERENCE VALUE STORAGE UNIT
115
DETERMINING UNIT
120
121
CODE TABLE STORAGE UNIT
123
COMPARISON UNIT
130
DATA WORD PROBABILITY VALUE CALCULATION UNIT
To DECODER

FIG. 2

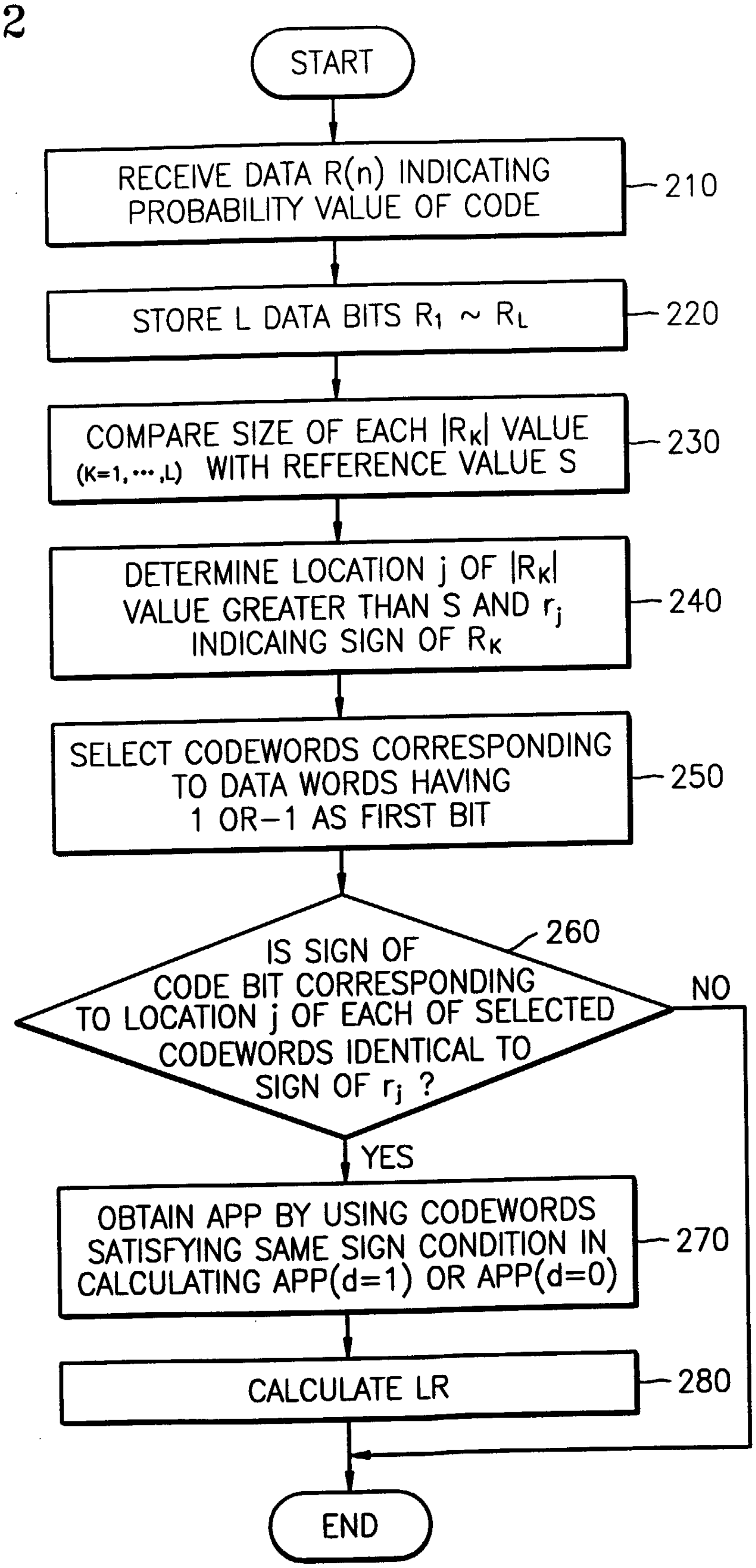
START
RECEIVE DATA R(n) INDICATING PROBABILITY VALUE OF CODE
210
STORE L DATA BITS $R_1 \sim R_L$
220
COMPARE SIZE OF EACH $|R_K|$ VALUE (K=1,···,L) WITH REFERENCE VALUE S
230
DETERMINE LOCATION j OF $|R_K|$ VALUE GREATER THAN S AND $r_j$ INDICAING SIGN OF $R_K$
240
SELECT CODEWORDS CORRESPONDING TO DATA WORDS HAVING 1 OR−1 AS FIRST BIT
250
IS SIGN OF CODE BIT CORRESPONDING TO LOCATION j OF EACH OF SELECTED CODEWORDS IDENTICAL TO SIGN OF $r_j$ ?
260
NO
YES
OBTAIN APP BY USING CODEWORDS SATISFYING SAME SIGN CONDITION IN CALCULATING APP(d=1) OR APP(d=0)
270
CALCULATE LR
280
END

FIG. 3A

| INPUT DATA BIT | CHANNEL BIT |
|---|---|
| 00 | 101 |
| 01 | 100 |
| 10 | 001 |
| 11 | 010 |

FIG. 3B

| INPUT DATA BIT | CHANNEL BIT |
|---|---|
| 00.00 | 101.000 |
| 00.01 | 100.000 |
| 10.00 | 001.000 |
| 10.01 | 010.000 |

# FIG. 4

| DATA WORD | 00 | 01 | 10 | 11 |
|---|---|---|---|---|
| CODEWORD | 040 | 041 | 010 | 021 |
| | 050 | 042 | 011 | 022 |
| | 051 | 044 | 012 | 024 |
| | 052 | 045 | 020 | 025 |
| | 101 | 201 | 110 | 121 |
| | 102 | 202 | 111 | 122 |
| | 104 | 204 | 112 | 124 |
| | 105 | 205 | 120 | 125 |
| | 240 | 241 | 210 | 221 |
| | 250 | 242 | 211 | 222 |
| | 251 | 244 | 212 | 224 |
| | 252 | 245 | 220 | 225 |
| | 440 | 401 | 410 | 421 |
| | 450 | 402 | 411 | 422 |
| | 451 | 404 | 412 | 424 |
| | 452 | 405 | 420 | 425 |
| | 501 | 441 | 510 | 521 |
| | 502 | 442 | 511 | 522 |
| | 504 | 444 | 512 | 524 |
| | 505 | 445 | 520 | 525 |

FIG. 5

| $R_K$ | -0.8 | 0 | 0 | 0.8 | 0 | 0.7 | 0 | 0 | -0.9 |
|---|---|---|---|---|---|---|---|---|---|
| CODEWORD | 0 | 0 | 0 | 1 | 0 | 0 | 0 | 0 | 0 |
| | 0 | 0 | 0 | 1 | 0 | 1 | 0 | 0 | 0 |
| | 0 | 0 | 0 | 1 | 0 | 1 | 0 | 0 | ✱ |
| | 0 | 0 | 0 | 1 | 0 | 1 | 0 | 1 | 0 |
| | | ⋮ | | | ⋮ | | | ⋮ | |
| | ✱ | 0 | 0 | 1 | 0 | 0 | 0 | 0 | ✱ |
| | ✱ | 0 | 0 | 1 | 0 | 0 | 0 | 1 | 0 |
| | ✱ | 0 | 0 | 1 | 0 | 0 | 1 | 0 | 0 |
| | ✱ | 0 | 0 | 1 | 0 | 0 | 1 | 0 | ✱ |

European Patent Office

# EUROPEAN SEARCH REPORT

Application Number
EP 03 25 2226

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | EP 1 187 335 A (SAMSUNG ELECTRONICS CO LTD) 13 March 2002 (2002-03-13)<br>* the whole document *<br>--- | 1-15 | H03M5/14<br>H03M13/45<br>G11B20/14 |
| A | EP 1 047 197 A (SAMSUNG ELECTRONICS CO LTD) 25 October 2000 (2000-10-25)<br>* the whole document *<br>--- | 1-15 | |
| A | EP 0 351 055 A (MATSUSHITA ELECTRIC IND CO LTD) 17 January 1990 (1990-01-17)<br>--- | | |
| D,A | ROBERTSON P ET AL: "A COMPARISON OF OPTIMAL AND SUB-OPTIMAL MAP DECODING ALGORITHMS OPERATING IN THE LOG DOMAIN" COMMUNICATIONS - GATEWAY TO GLOBALIZATION. PROCEEDINGS OF THE CONFERENCE ON COMMUNICATIONS. SEATTLE, JUNE 18 - 22, 1995, PROCEEDINGS OF THE CONFERENCE ON COMMUNICATIONS (ICC), NEW YORK, IEEE, US, vol. 2, 18 June 1995 (1995-06-18), pages 1009-1013, XP000533149<br>ISBN: 0-7803-2487-0<br>----- | | TECHNICAL FIELDS SEARCHED (Int.Cl.7)<br>H03M<br>G11B |

The present search report has been drawn up for all claims

| Place of search | Date of completion of the search | Examiner |
|---|---|---|
| THE HAGUE | 29 September 2003 | Devergranne, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 03 25 2226

This annex lists the patent family members relating to the patent documents cited in the above-mentioned European search report.
The members are as contained in the European Patent Office EDP file on
The European Patent Office is in no way liable for these particulars which are merely given for the purpose of information.

29-09-2003

| Patent document cited in search report | Publication date | Patent family member(s) | Publication date |
|---|---|---|---|
| EP 1187335 A | 13-03-2002 | KR 2002019674 A | 13-03-2002 |
| | | CN 1341932 A | 27-03-2002 |
| | | EP 1187335 A2 | 13-03-2002 |
| | | JP 2002135121 A | 10-05-2002 |
| | | US 2002060634 A1 | 23-05-2002 |
| EP 1047197 A | 25-10-2000 | KR 2000067781 A | 25-11-2000 |
| | | CN 1274998 A | 29-11-2000 |
| | | EP 1047197 A2 | 25-10-2000 |
| | | JP 2000339871 A | 08-12-2000 |
| | | US 6281815 B1 | 28-08-2001 |
| EP 0351055 A | 17-01-1990 | JP 1311726 A | 15-12-1989 |
| | | DE 68924733 D1 | 14-12-1995 |
| | | DE 68924733 T2 | 30-05-1996 |
| | | EP 0351055 A1 | 17-01-1990 |
| | | KR 9300453 B1 | 21-01-1993 |
| | | US 5016258 A | 14-05-1991 |
| | | JP 2139767 A | 29-05-1990 |

EPO FORM P0459

For more details about this annex : see Official Journal of the European Patent Office, No. 12/82